# EUROPEAN PATENT APPLICATION

(11) **EP 3 754 850 A1**
(43) Date of publication of application: **23.12.2020**
(21) Application number: 19180960.7
(22) Date of filing: 18.06.2019
(51) Int. Cl.: H03K 19/003, G01F 23/00, G01F 23/74, G05F 3/30

(54) **SENSOR ASSEMBLY FOR MEASURING THE LEVEL OF A LIQUID**

(71) Applicant: TE Connectivity Norge AS, 5258 Blomsterdalen (NO)
(72) Inventor: Jansson, Niklas, 5232 Paradis (NO)
(74) Representative: Grünecker Patent- und Rechtsanwälte PartG mbB

(57) **Abstract**

The application shows a sensor assembly (100) for measuring the level of a liquid (90), in particular Diesel Exhaust Fluid (DEF), wherein the sensor assembly (100) comprises a measuring section (40) through which during operation of the sensor assembly (100), a measuring current (41) runs, wherein the sensor assembly (100) further comprises a temperature compensation section (20) which is configured to compensate temperature dependent variations of the measuring current (41) within a predetermined operational temperature range.

## Description

The invention relates to a sensor assembly for measuring the level of a liquid, in particular Diesel Exhaust Fluid, also known as DEF or ADBlue.

Such sensor assemblies usually comprise a measuring section through which during operation of the sensor assembly, a measuring current runs.

A problem associated with the present solutions is that they can only be used in a limited range of temperatures.

An object of the invention is thus to provide a solution that can be used in a wider range of temperatures.

This object is achieved when the sensor assembly further comprises a temperature compensation section which is configured to compensate temperature dependent variations of the measuring current within a predetermined operational temperature range.

The compensation of the temperature dependent variations allows using the sensor assembly in a wider range of temperatures.

The solution according to the invention can further be improved by the following further embodiments and advantageous developments, which are independent of each other and can be combined arbitrarily, as desired.

The temperature compensation section can be part of a current source in order to compensate the temperature variations in this part. The temperature compensation section can also be located next to the current source, for example at an output of the current source. It can, in particular, be connected to a current source directly, that is without any intermediate elements between the temperature compensating section and the current source.

In further embodiments, the temperature compensation section can be located in different parts, for example in the measuring section in order to compensate temperature dependent variations in these parts.

The temperature compensation section can comprise an element that regulates the current or the voltage in an electric circuit. Through this, temperature dependent variations of the current or the voltage can be compensated.

In an advantageous development, the sensor assembly comprises an output section for outputting output values representing different levels of the liquid, wherein within the predetermined operational temperature range, the output values are independent or almost independent of an operation temperature. A variation of 10%, preferably 5%, more preferably 2% can be considered almost independent. The independence can be due to the temperature compensation section.

The output values can, in particular, be voltages. A further processing of the output values can thus be easy, as voltages are often used in signal processing. The output values can be digital values, meaning that they have predetermined voltage levels.

Advantageously, the sensor assembly is configured to generate a constant current in the measuring section. Through this, for example, voltages can be used as signals.

In order to allow a measurement, the sensor assembly can comprise switches and resistors, each switch being associated with one resistor. The switches can serve to change the configuration of an electrical circuit and, for example, connect certain parts of the electric circuit to other parts, depending on the level of the liquid. The resistors can be operatively connected to the switches so that depending on the switching status of the switch, the associated resistor is or is not part of the electrical circuit. On the other hand, each resistor can be associated with one switch to keep the construction simple.

The switches can be magnetically switching switches, in particular reed switches. Such magnetically switching or magnetically triggered switches can be triggered by a magnetic element depending on the level of the liquid.

The resistors between neighboring switches can have the same resistance value. This reduces the complexity of the manufacturing process as only one type of resistor has to be kept in stock. In particular, all the resistors in the measuring section can have the same resistance value.

In the measuring section, resistors can be arranged serially behind each other. This has the advantage of an easy layout of the electric circuit.

The sensor assembly can comprise a float that is movable relative to the measuring section along a measuring direction.

In an advantageous embodiment, the float is configured to float on the liquid and comprises a triggering section. The triggering section is configured to operate a switch if the switch is within a predetermined distance from the float. The predetermined distance can be below 20 cm, preferably below 10 cm, more preferably below 5 cm to allow a precise measurement. The predetermined distance can be such that the float has to be in contact with an element comprising the switch to trigger the switch.

Advantageously, the float comprises a magnet for switching magnetically switching or magnetically triggered switches to allow a simple operation.

In order to allow a precise measurement along the measuring direction, the switches can be arranged spaced apart from each other along the measuring direction. The switches can have predetermined and/or equal distances from each other. In a further embodiment, in one part, some switches each have a first equal distance to each other while in a further part, switches have a different distance, for example to allow a more precise measurement of the level of the liquid in this part.

To allow a simple and compact layout, each switch can be connected on one side to a voltage level common to all switches, in particular to the ground.

In an advantageous embodiment, when the float is within the predetermined distance from a switch, an electrical circuit is closed via the switch. If the float is not within the predetermined distance from this particular switch, the electric circuit can be open or closed via a different switch. This allows an easy determination of the level of the liquid.

In a further embodiment, the circuit can comprise a different number of resistors depending on the level or position of the float. Depending on the level of the liquid and the position of the float, the measuring current can run through a different number of resistors.

Different levels of the liquid can be associated with different switches. If the liquid has a certain level, an associated switch can be triggered or switched, it can for example be closed.

Every switch can be associated with a different resistance in the electric circuit. Further, every resistance value in the electric circuit can be associated with a different number of resistors. In particular, each of the resistors can have the same resistance value, which can be a standardized or common resistance value.

The temperature compensation section can comprise a first transistor and a second transistor, wherein the temperature dependence of the first transistor and the second transistor compensate each other at least over the predetermined operational range.

The temperature compensating section can be located in a current source. The first transistor and the second transistor can be located in such a way that they are exposed to the same temperature to minimize the voltage differences in their temperature dependent base-emitter junctions.

The temperature compensation section can comprise a first transistor, wherein the first transistor has a positive temperature coefficient, and a second transistor, wherein the second transistor has a negative temperature coefficient, and wherein the temperature coefficient of the first transistor and the second transistor compensate each other at least over the predetermined operational range. This allows for an easy design.

For example, the temperature coefficient of the first transistor and the second transistor can be inverse to each other at least over the predetermined operational range.

In particular, one of the first and second transistors can be a PNP-transistor and the other one of the first and second transistors can be an NPN-transistor.

In a further embodiment, the sensor assembly can comprise a group of three or more transistors, wherein the transistors in the group are adapted to each other to result in a temperature compensated overall coefficient.

For example, at a given operational temperature within the operational temperature range, a transistor can compensate the remainder.

In a further advantageous embodiment, the at least two transistors or the group of transistors can compensate the temperature coefficient of further electrical elements, in particular of resistors.

The invention will now be described in greater detail and in an exemplary manner using advantageous embodiments and with reference to the drawings. The described embodiments are only possible configurations in which, however, the individual features as described above can be provided independently of one another or can be omitted.

In the figures:
- Fig. 1: shows a schematic view of a sensor assembly;
- Fig. 2: shows a schematic view of a measuring section of a sensor assembly;
- Fig. 3: shows a schematic view of the measuring section of Fig. 2 together with a float;
- Fig. 4: shows a schematic view of a current source; and
- Fig. 5: shows a schematic view of a further embodiment of a current source.

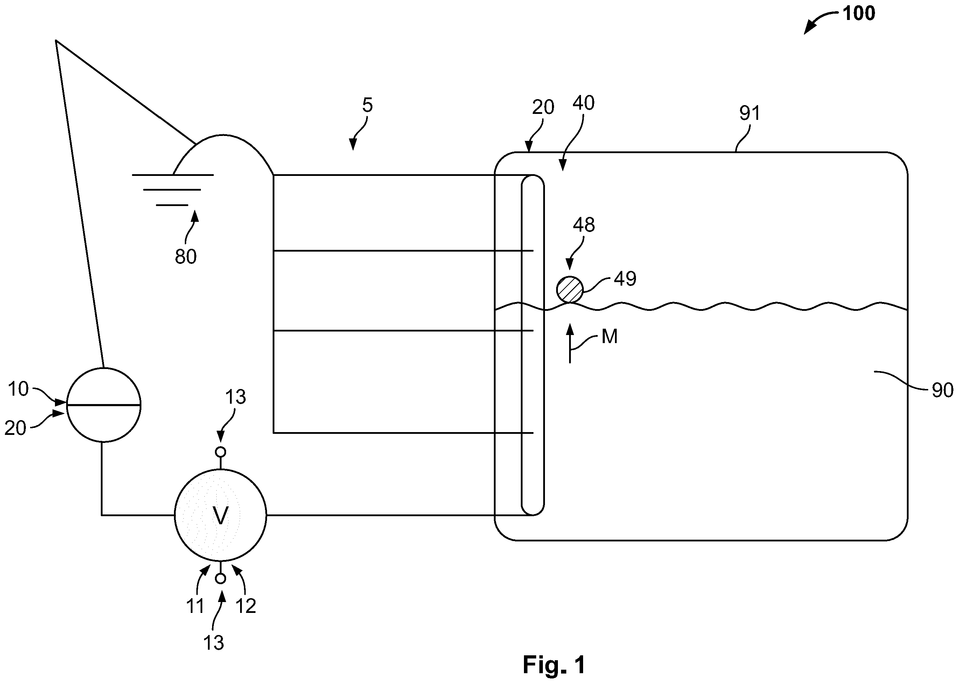

Fig. 1 gives an overview of a sensor assembly 100 used for measuring the level of a liquid 90 that is for example retained in a tank 91. The liquid can for example be Diesel Exhaust Fluid (DEF) that is used for the treatment of exhaust gases in automobiles.

A float 49 floats on the liquid 90 and triggers one or more switches 42 at a time when it is within a predetermined distance 70 from the switch 42. The switches 42 can for example be reed switches that react to magnetic forces generated by a magnet of the float 49. The float 49 can move along a measuring direction M.

The sensor assembly 100 comprises a measuring section 40 for measuring the level of the liquid 90 along the measuring direction M.

The sensor assembly 100 further comprises a current source 10 that provides a constant current.

Further, the sensor assembly 100 comprises a voltage meter 11 that measures the voltage in the electrical circuit 5 of the sensor assembly 100. The voltage is indicative of the level of the liquid 90 in the tank 91.

The voltage meter 11 can thus serve as an output section 12 where output values representing different levels of the liquid 90 can be output. Therefore, the voltage meter 11 can comprise outputs 13 at which the voltage or signals representing the voltage can be output and be taken up by an external element, for example for further processing.

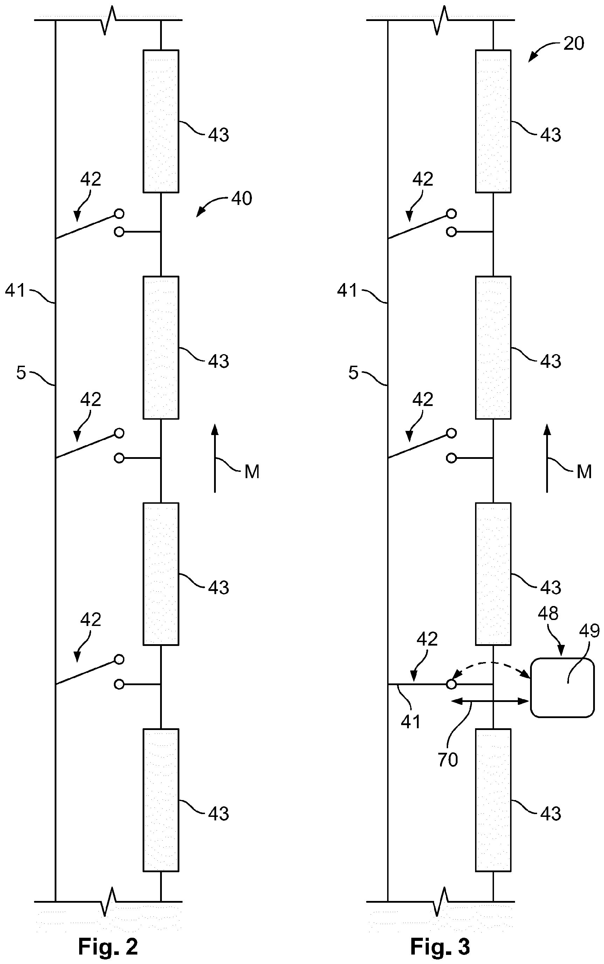

As can be seen in Figs. 2 and 3, the measuring section 40 comprises several resistors 43 that are located along a measuring direction M and connected serially to each other. Fig. 2 shows the measuring section 40 without the float 49. Consequently, all of the switches 42 are in an open state.

In Fig. 3, the float 49 which comprises a triggering section 48 with a magnet (not shown) is located close to one of the switches 42 and in particular within a predetermined distance 70 so that the switch 42 is closed. Consequently, the electric circuit is closed via this switch 42 and the voltage and the electric circuit 5 changes relative to the situation shown in Fig. 2.

Depending on the position of the float 49 along the measuring direction M, a varying number of resistors 43 are part of the electric circuit 5 and consequently, the voltage changes for each of the positions. This allows reducing the position of the float 49 and thus of the level of the liquid 90 based on the voltage in the electric circuit 5. At one side, the switches are connected to a common voltage level, in particular to a ground 80.

Different levels of the liquid 90 are thus associated with different switches 42. Each switch 42 is associated with a different resistance value of the electric circuit 5. Every resistance value is associated with a specific number of resistors 43, that could have the same value.

The switches 42 can be spaced from each other at equal distances. In other embodiments, the distances can vary and in particular be smaller in areas where a higher resolution is desired.

Each switch 42 is associated with one resistor 43. Further, each of the resistors 43 has the same resistance value. This makes production easy as only one type of resistor has to be kept in stock and the risk that the production has to be paused is reduced.

The sensor assembly 100 comprises at least one temperature compensation section 20 for compensating temperature dependent variations of the measuring current 41 within the predetermined operational temperature range. The sensor assembly 100 can, for example, be used in automobiles or in machinery that is exposed to low environmental temperatures in the winter and high environmental temperatures in the summer. The sensor assembly 100 can be used in a wide operational temperature range due to the temperature compensation section 20. In particular, the operational range can, for example, go from -40°C to +105°C. In the operational temperature range, the measuring current 41 is basically constant, meaning that the variation is less than 10%, preferably less than 5%, more preferably less than 2%.

Furthermore, the output values measured at the output section 12 can also be independent of the temperature within the operational temperature range. However, the values of course vary depending on the level of the liquid 90 in the tank 91.

The temperature compensation section 20 can be part of the current source 10 so that the current that is generated therein is independent of the temperature. Furthermore, the sensor assembly 100 can comprise a temperature compensation section 20 in the measuring section 40.

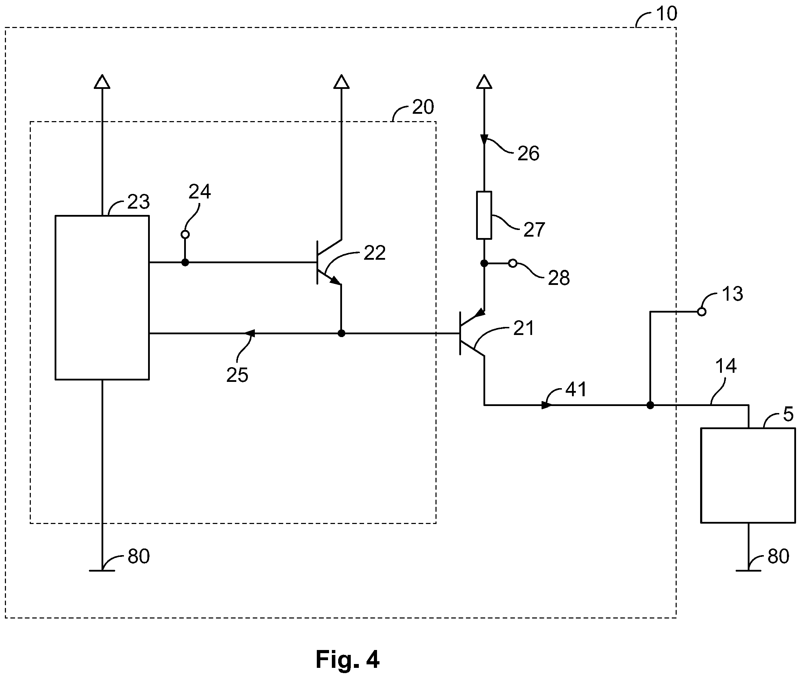

Fig. 4 shows a version in which the temperature compensating section 20 is located in the current source 10. The temperature compensation section 20 can, in particular, comprise a first transistor 21 and a second transistor 22, which are only shown schematically. Both transistors 21 and 22 are located in such a way that they are exposed to the same temperature to minimize the voltage differences in their temperature dependent base-emitter junctions.

The current source 10 is regulating a shunt resistor current 26 based on a reference voltage 24, provided by the temperature compensation section 20. The goal is to regulate a shunt resistor voltage 28 to the same voltage as the reference voltage 24.

The shunt resistor current 26 is the sum of a biasing current 25 and the measuring current 41. However, the biasing current 25 can be fixed and also very small in comparison to the measuring current 41, so the measurement error can be neglected.

Advantageously, the temperature dependence of the two transistors 21, 22 can cancel each other out so that the overall temperature performance or overall temperature coefficient is 0 or almost 0, at least over the predetermined operational range. The output current measured at the contacts 14 is then independent of the temperature.

The first transistor can be a PNP-transistor and the second transistor can be an NPN-transistor.

Fig. 4 shows the use of two transistors 21, 22. However, more than two transistors 21, 22 can be used. For example, the temperature compensation section 20 can comprise three, four, five or more transistors 21, 22. The group of transistors 21, 22 can be adapted to each other to result in a temperature compensated overall coefficient.

At least one temperature compensation section 20 can also be part of the measuring section 40.

The temperature compensation section 20 can, in particular, comprise elements that regulate the current or the voltage.

Temperature compensation section 20 can also take account of temperature dependencies in other elements, in particular the resistors 42. However, the resistance of such resistors are usually less dependent on the temperature.

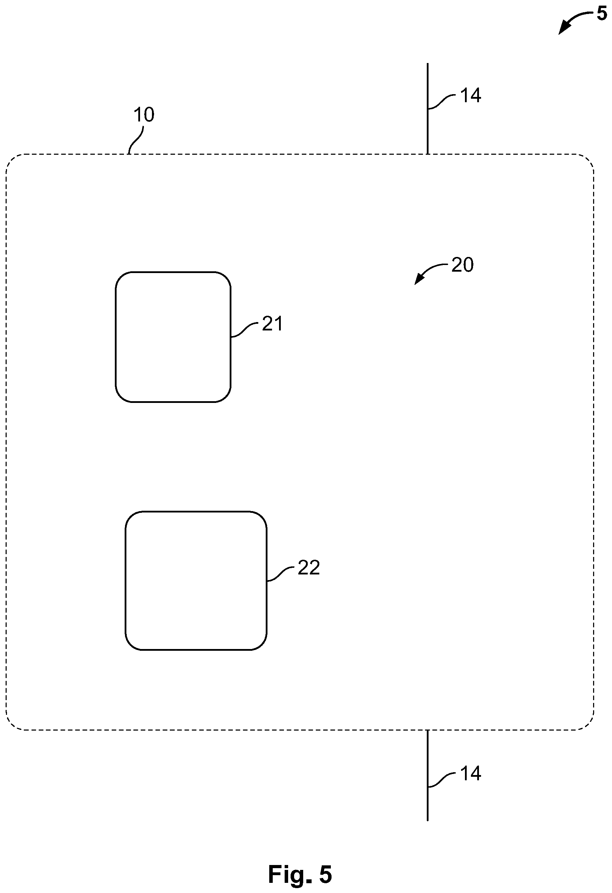

In Fig. 5, a further advantageous development is shown. The temperature compensating section 20 is again located in the current source 10. The temperature compensation section 20 can, in particular, comprise a first transistor 21 and a second transistor 22, which are only shown schematically. One of the transistors 21, 22 has a positive temperature coefficient and the other transistor 22, 21 has a negative temperature coefficient. Positive temperature coefficients and negative temperature coefficients mean that the output of the transistor 21, 22 increases or decreases, respectively, when the temperature increases.

Advantageously, the temperature coefficients of the two transistors 21, 22 are inverse and cancel each other out so that the overall temperature performance or overall temperature coefficient is 0 or almost 0, at least over the predetermined operational range. The output current measured at the contacts 14 is then independent of the temperature.

### REFERENCE NUMERALS

- 5: electric circuit
- 10: current source
- 11: voltage meter
- 12: output section
- 13: output
- 14: contact
- 20: temperature compensation section
- 21: first transistor
- 22: second transistor
- 23: reference and biasing network
- 24: reference voltage
- 25: biasing current
- 26: shunt resistor current
- 27: shunt resistor
- 28: shunt resistor voltage
- 40: measuring section
- 41: measuring current
- 42: switch
- 43: resistor
- 48: triggering section
- 49: float
- 70: distance
- 80: ground
- 90: liquid
- 91: tank
- 100: sensor assembly
- M: measuring direction

## Claims

1. Sensor assembly (100) for measuring the level of a liquid (90), in particular DEF, wherein the sensor assembly (100) comprises a measuring section (40) through which during operation of the sensor assembly (100), a measuring current (41) runs, wherein the sensor assembly (100) further comprises a temperature compensation section (20) which is configured to compensate temperature dependent variations of the measuring current (41) within a predetermined operational temperature range.

2. Sensor assembly (100) according to claim 1, wherein the temperature compensation section (20) is a part of a current source (10).

3. Sensor assembly (100) according to one of claims 1 or 2, wherein the sensor assembly (100) is configured to generate a constant current in the measuring section (40) .

4. Sensor assembly (100) according to one of claims 1 to 3, wherein the sensor assembly (100) comprises switches (42) and resistors (43), each switch (42) being associated with one resistor (43).

5. Sensor assembly (100) according to one of claims 1 to 4, wherein, in the measuring section (14), resistors (43) are arranged serially behind each other.

6. Sensor assembly (100) according to one of claims 1 to 5, wherein the resistors (43) between neighboring switches (42) have the same resistance value.

7. Sensor assembly (100) according to one of claims 1 to 6, wherein the sensor assembly (100) comprises a float (49) that is movable relative to the measuring section (40) along a measuring direction M.

8. Sensor assembly (100) according to one of claims 1 to 7, wherein the float (49) is configured to float on the liquid (90) and comprises a triggering section (48) and the triggering section (48) is configured to operate a switch (42) if the switch (42) is within a predetermined distance (70) from the float (49).

9. Sensor assembly (100) according to one of claims 1 to 8, wherein the temperature compensation section (20) comprises a first transistor (21) and a second transistor (22), wherein the temperature dependence of first transistor (21) and the second transistor (22) compensate each other at least over the predetermined operational range.

10. Sensor assembly (100) according to one of claims 1 to 9, wherein the temperature compensation section (20) comprises a first transistor (21), wherein the first transistor (21) has a positive temperature coefficient, and a second transistor (22), wherein the second transistor (22) has a negative temperature coefficient, and wherein the temperature coefficient of first transistor (21) and the second transistor (22) compensate each other at least over the predetermined operational range.

11. Sensor assembly (100) according to claim 10, wherein the temperature coefficient of the first transistor (21) and the second transistor (22) are inverse to each other at least over the predetermined operational range.

12. Sensor assembly (100) according to one of claims 1 to 11, wherein one of the first and the second transistors (21, 22) is a PNP-transistor and the other one of the first and second transistors (22, 21) is an NPN-transistor.

13. Sensor assembly (100) according to one of claims 1 to 12, wherein the sensor assembly comprises a group of three or more transistors (21, 22) and the transistors (21, 22) in the group are adapted to each other to result in a temperature compensated overall coefficient.

14. Sensor assembly (100) according to one of claims 1 to 13, wherein the at least two transistors (21, 22) or the group of transistors (21, 22) compensates the temperature coefficient of further electrical elements, in particular of resistors (43).
